(19) Europäisches Patentamt
European Patent Office
Office européen des brevets

(11) **EP 1 312 115 B1**

(12) **EUROPÄISCHE PATENTSCHRIFT**

(45) Veröffentlichungstag und Bekanntmachung des Hinweises auf die Patenterteilung:
**20.05.2009 Patentblatt 2009/21**

(51) Int Cl.:
*H01L 23/64* (2006.01)    *H01L 21/762* (2006.01)
*H01L 21/02* (2006.01)

(21) Anmeldenummer: **01962562.3**

(22) Anmeldetag: **18.07.2001**

(86) Internationale Anmeldenummer:
**PCT/DE2001/002701**

(87) Internationale Veröffentlichungsnummer:
**WO 2002/017399 (28.02.2002 Gazette 2002/09)**

(54) **HALBLEITERANORDNUNG UND VERFAHREN ZU DESSEN HERSTELLUNG**

SEMICONDUCTOR ARRANGEMENT AND METHOD FOR PRODUCTION THEREOF

DISPOSITIF A SEMI-CONDUCTEURS ET SON PROCEDE DE PRODUCTION

(84) Benannte Vertragsstaaten:
**AT BE CH CY DE DK ES FI FR GB GR IE IT LI LU MC NL PT SE TR**

(30) Priorität: **24.08.2000 DE 10041691**

(43) Veröffentlichungstag der Anmeldung:
**21.05.2003 Patentblatt 2003/21**

(73) Patentinhaber: **Infineon Technologies AG**
**81669 München (DE)**

(72) Erfinder: **BRENNER, Pietro**
**85764 Oberschleissheim (DE)**

(74) Vertreter: **Epping - Hermann - Fischer**
**Patentanwaltsgesellschaft mbH**
**Ridlerstraße 55**
**80339 München (DE)**

(56) Entgegenhaltungen:
EP-A- 0 844 660      EP-A- 0 966 040
WO-A-01/20649      WO-A-97/45873
DE-A- 3 825 547      GB-A- 2 226 445
KR-A- 20000 033 521      US-A- 5 665 633
US-A- 5 742 091      US-A- 6 093 599
US-B1- 6 274 920

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Halbleiteranordnung mit einem Substrat, das wenigstens ein darin integriertes Bauelement, insbesondere einen Transistor, mit einem diesen umgebenden Trench-Graben aufweist und auf dessen erster Hauptseite eine Metallisierung vorgesehen ist, wobei zumindest Teile der Metallisierung mit einer in dem Substrat gelegenen Isolationsschicht unterlegt sind.

Beim Übertragen von Signalen im Bereich ab einigen Gigahertz über Leiterbahnen, großflächige passive Bauelemente sowie bei der Signaleinspeisung und der Signalauskopplung an großflächigen Anschlußelementen, den sogenannten Kontaktierpads, kommt es zu erheblichen Verlusten in der Signalleistung und zu Beeinträchtigungen der Signalqualität aufgrund parasitärer Kapazitäten. Die parasitären Kapazitäten sind aufgrund der kapazitiven Kopplung zwischen den genannten Metallflächen und dem Halbleitersubstrat unvermeidlich.

Um eine gute und verlustarme Signalübertragung auch im hohen Gigahertzbereich sinnvoll realisieren zu können, müssen diese Signalverluste so gering als möglich gehalten werden. Dies gilt sowohl für den Betrieb einer Halbleiteranordnung, zum Beispiel im Telekommunikationsbereich, als auch bei der meßtechnischen Untersuchung der Halbleiteranordnungen.

Zum Messen und Testen der Signalübertragungseigenschaften werden sogenannte s-Parametermessungen durchgeführt. Bei dieser Messung wird ein hochfrequentes Kleinsignal mit Signalfrequenzen von bis zu 50 GHz von den Anschlußelementen über eine metallische "on-wafer"-Zuführungsleitung möglichst verlust- und verzerrungsarm an die zu messende Halbleiteranordnung weitergeleitet. Zur Einspeisung wird ein sogenannter HF-Probekopf auf die auf dem Wafer befindlichen Anschlußelemente aufgesetzt, der dann das Signal einspeist und die transmittierten und reflektierten Signalanteile in einem 50 $\Omega$-System zum Meßgerät weiterleitet. Die Zuführungsleitungen von den Anschlußelementen zu der zu messenden Halbleiteranordnung betragen typischerweise 10 bis einige 100 $\mu$m. Abhängig von der Signalfrequenz werden die transmittierten und reflektierten Signalleistung präzise gemessen. Bei Signalfrequenzen im hohen Gigahertzbereich kommt es besonders an den Anschlußelementen aufgrund der kapazitiven Signaleinkopplung in das Substrat der Halbleiteranordnung zu unerwünschten Signalleistungsverlusten.

Zur Reduzierung der parasitären Kapazitäten, Induktivitäten und Serienwiderstände ist es bekannt, die Anschlußelemente sowie die Zuleitungen (Leiterbahnen) möglichst klein auszuführen. Aufgrund der verfügbaren Probeköpfe einer Meßeinrichtung sind diesem Vorgehen jedoch enge Grenzen gesetzt. Ebenfalls wird die Minimierung durch eine Mindestfläche für die Anschlußelemente begrenzt. Da bei einem HF-Design einer Halbleiteranordnung mit zunehmender Arbeitsfrequenz die Stromdichten stetig zunehmen, müßten die Zuleitungen beziehungsweise Leiterbahnen eher vergrößert denn verkleinert werden, damit die damit einhergehende Zunahme der Leitungsinduktivitäten und der Serienwiderstände in tolerierbaren Grenzen gehalten werden können.

Die Signalleistungsverluste können auch dadurch verringert werden, daß eine Erhöhung des Substratwiderstandes vorgenommen wird. Mit der Erhöhung des spezifischen Widerstandes des Substrates nimmt jedoch die Latch-Up-Anfälligkeit und die Substratverkopplung zwischen verschiedenen Schaltungsblöcken erheblich zu. Der Erhöhung des spezifischen Substratwiderstandes sind somit aus prozesstechnischen Überlegungen enge Grenzen gesetzt.

Zur Reduzierung der Verluste bei integrierten Spulen ist es aus dem Artikel "Novell Burried Oxide Isolation for Monolitic RF Inductors on Silicon" von H.B. Erzgräber, T. Grabolla, H.H. Richter, P. Schley und A. Wolff, IEDM 98, Seiten 535 bis 539 bekannt, eine Isolationsschicht im Substrat unterhalb der integrierten Spule vorzusehen. Hierbei wird eine Trench-Isolationstechnik mit sehr großen Trench-Tiefen verwendet, bei der die verbleibenden parallelen Silizium-Stege vollständig aufoxidiert werden. Das in dem Artikel beschriebene Verfahren dient zur Verbesserung der Güte der integrierten Spule, wobei die relevanten Verluste in den Wirbelströmen im tieferen Substrat zu suchen sind. Aufgrund dessen sind verhältnismäßig tiefe Trenches notwendig, was die Herstellung verkompliziert. Durch den dort durchgeführten "harten" Oxidationsschritt werden in dem Substrat befindliche Bipolar- und CMOS-Transistoren zerstört, so daß das dort vorgeschlagene Verfahren nur bedingt einsetzbar ist.

In der US 5 665 633 ist ein Verfahren zur Herstellung von Halbleiterbauelementen mit einem Feldisolationsbereich beschrieben, bei dem ein rechteckiges Doppelgitter aus Gräben hergestellt wird, eine thermische Oxidation vorgenommen wird, um an den Oberflächen der Gräben eine Oxidschicht zu bilden, und die Gräben mit isolierendem Material gefüllt werden. Zusammen mit den Gräben werden weitere Gräben hergestellt, die eine Transistorstruktur seitlich isolieren.

In der US 6 093 599 ist ein Herstellungsverfahren für ein Bauelement auf einem Siliziumsubstrat beschrieben, bei dem Gräben im Substrat mit undotiertem Polysilizium gefüllt werden, um parasitäre Kapazitäten zwischen einer oberseitigen Induktivität und dem Substrat zu reduzieren.

In der DE 38 25 547 A1 ist ein Herstellungsverfahren für einen isolierenden Bereich in einem Halbleitersubstrat beschrieben, bei dem drei parallele Gräben gebildet werden, deren Innenseiten thermisch oxidiert werden, so dass die Gräben aufgrund der damit einhergehenden Volumenvergrößerung mit dem gebildeten Oxid gefüllt werden.

In der KR 2000 0033521 A und der US 6 274 920 B1 ist ein Herstellungsverfahren für ein Bauelement mit integrierter Induktivität beschrieben, bei dem obere Randbereiche paralleler Gräben mit Anteilen einer dielektrischen Schicht versehen werden. Hohlräume innerhalb der auf diese Weise verschlossenen Gräben sollen in Verbindung mit einem umgebenden dotierten Bereich zur Reduktion parasitärer Kapazität und magnetischer Kopplung dienen.

In der EP 844660 A1 ist ein Herstellungsverfahren beschrieben, bei dem zwischen einer metallischen Zeitung und einem Halbleitersubstrat in dem Halbleitersubstrat ein p-n-Übergang zur Reduktion parasitärer Kapazitäten geformt wird.

Aufgabe der vorliegenden Erfindung ist es, ein Verfahren zur Herstellung einer Halbleiteranordnung unter Verwendung herkömmlicher Prozessschritte anzugeben, mit dem eine verbesserte Reduzierung kapazitiver Verlustströme in das Substrat bei hochfrequenten Signalen erreicht wird.

Diese Aufgabe wird mit dem Verfahren mit den Merkmalen des Anspruches 1 gelöst. Vorteilhafte Ausgestaltungen ergeben sich aus dem abhängigen Anspruch.

Erfindungsgemäß ist vorgesehen, die Isolationsschicht in Form eines Trench-Gitters zu realisieren, wobei das Trench-Gitter und ein das integrierte Bauelement umgebender Trench-Graben in dem gleichen Verfahrensschritt herstellbar sind.

Der Erfindung liegt die Erkenntnis zugrunde, daß die kapazitiven Verlustströme in das Substrat direkt proportional zur Fläche der Metallisierung und direkt proportional zur Signalfrequenz, jedoch indirekt proportional zum Abstand zwischen dem Substrat und der das Signal führenden Metallisierung sind. Der dominierende Verlusteffekt bei der Signalübertragung ist die Einkopplung eines Hochfrequenzsignals in das Halbleitersubstrat. Die flächenspezifische kapazitive Leitfähigkeit pro Metallisierungs-Flächeneinheit A ist gegeben durch:

$$y_A = 2\pi f \epsilon_0 \epsilon_r / d,$$

wobei f die Signalfrequenz, $\epsilon_0$ die elektrische Feldkonstante, $\epsilon_r$ die Dielektrizitätskonstante des Isolationsmaterials zwischen der Metallisierung und dem Substrat und d der räumliche Abstand zwischen der Metallisierung und dem Substrat ist. Durch die Verwendung von Materialien mit möglichst kleinem $\epsilon_r$ kann diese spezifische Leitfähigkeit signifikant verringert werden. Diese Materialien sind unter dem Namen "Low-k-Dielectrics" bekannt.

Eine Reduzierung der spezifischen Leitfähigkeit ist gemäß obiger Formel weiterhin dadurch möglich, daß der Abstand d zwischen der Metallisierung und dem Substrat vergrößert wird.

Die Erfindung schlägt eine sehr einfache und effiziente Möglichkeit vor, diesen Abstand mit einer in vielen modernen Halbleitertechnologien verfügbaren Prozeßtechnik zu erzeugen und hierdurch die parasitären Kapazitäten erheblich zu reduzieren.

Dadurch, daß in dem Substrat eine Isolationsschicht in Form eines Trench-Gitters vorgesehen ist, kann dieser Abstand d je nach verfügbarer Trench-Tiefe um den Faktor 2 bis 3 vergrößert werden. Im Bereich des Trench-Gitters kann bei Bedarf eine niederohmige Feldimplantation weggelassen werden. Die im Trench-Gitter verbleibenden Säulen bestehen aus dem Halbleitersubstrat und sind hochohmig. Je hochohmiger das unter der Metallisierung befindliche Substrat ist, desto geringer sind die darin entstehenden Verluste durch Wirbelströme und den Substrat-Skin-Effekt.

Die Herstellung des Trench-Gitters ist denkbar einfach, da die Herstellungsverfahren aus dem Stand der Technik bekannt sind. Es ist zu dem kein zusätzlicher Prozeßschritt erforderlich, da um alle Transistoren in einem Substrat Trench-Gräben gefertigt werden. Mit anderen Worten bedeutet dies, daß das Trench-Gitter und ein das integrierte Bauelement umgebender Trench-Graben mit dem gleichen Verfahrensschritt hergestellt werden. Es ist lediglich die Verwendung einer abgeänderten Maske notwendig.

Die Trenches können durch einen trockenen Ätzprozeß, ein anschließendes naßchemisches Reinigen sowie durch anschließendes Auffüllen der Gräben mit einem Isolator, z.B. PSG-Glas, erzeugt werden. Eine vollständige Oxidation der verbleibenden Substratsäulen kann, muß aber nicht, zusätzlich erfolgen. Die Gestaltung des Gitters kann durch die Wahl einer geeigneten Maske erzeugt werden.

Die Erfindung läßt folglich nicht vollständig oxidierte Halbleiter-Restsäulen oder Reststege zu, die durch das Rauten- oder Rechteckmuster der Gräben des Trench-Gitters minimiert sind. Hierdurch läßt sich ohne Zusatzmasken bzw. zusätzliche Prozeßschritte ein optimiertes Halbleiterbauelement erzeugen, welches kostengünstig herstellbar ist.

Vorteilhafterweise reicht die Isolationsschicht an die erste Hauptseite des Substrates. Das Trench-Gitter ist vorteilhafterweise rechteck- oder rautenförmig ausgebildet. Werden die Zellen des Trench-Gitters in ihren Abmaßen derart beschaffen, daß bei dem möglichen - aber nicht notwendigen - auf das Grabenätzen folgenden Oxidationsschritt das Substratmaterial bis zur Ätztiefe des Grabens oxidiert wird, so entsteht ein Siliziumoxid, welches hochisolierend und eine kleine Dielektrizitätskonstante von $\epsilon_r = 3,3$ aufweist. Um eine möglichst vollständige Oxidation zu erzielen, ist es besonders vorteilhaft die Zellen des Gitters in einer Rechteck- oder Rautenform auszuführen.

Prinzipiell könnte - mit Ausnahme der Bauelemente der Halbleiteranordnung - die gesamte Hauptseite mit dem Trench-Gitter versehen werden. Es ist jedoch ausreichend, lediglich diejenigen Stellen der Metallisierung mit dem Trench-Gitter zu unterlegen, die bezüglich eines hochfrequenten Signales sensitiv sind. Üblicherweise weist die Metallisierung extern kontaktierbare Anschlußelemente (Kontaktpads), Polysilizium-Widerstände, Leiterbahnen und je nach Anwendungsfall auch integrierte Spulen auf, wobei erfindungsgemäß zumindest einige der Anschlußelemente, der integrierten Spulen, der Leiterbahnen oder der integrierten Polysilizium-Widerstände mit der Isolationsschicht unterlegt sind. Besonders kritisch sind großflächige Bauelemente, wie z.B. die extern kontaktierbaren Anschlußelemente oder integrierte Spulen, wobei lediglich diejenigen Anschlußelemente mit der Isolationsschicht unterlegt werden müssen, die sich im Signalpfad der Hochfrequenzsignale befinden.

In einer Ausgestaltung können die Anschlußelemente, die integrierten Spulen, zumindest signalkritische Teile der Leiterbahnen oder die integrierten Polysilizium-Widerstände jeweils mit einem zugeordneten Bereich der Isolationsschicht unterlegt sein. Dabei ist es vorteilhaft, wenn die Bereiche der Isolationsschicht über ein jeweiliges Anschlußelement, eine jeweilige integrierte Spule, den gewählten Teil der Leiterbahn oder einen jeweiligen integrierten Polysilizium-Widerstand seitlich hinausragen. Hierdurch können die Signalverluste reduziert werden.

Die Halbleiteranordnung kann sowohl eine Halbleiter-Teststruktur, ein Halbleiterchip als auch ein Wafer sein, wobei auf diesem Anschlußelemente zur Kontaktierung von Meßköpfen vorgesehen sind. Bei Anschlußelementen, welche zur Kontaktierung mit einem Meßkopf vorgesehen sind, müssen die parasitären Kapazitäten für eine korrekte Messung reduziert werden, um eine möglichst genaue Messung zu erhalten.

Die kapazitive Kopplung zum Substrat ist immer ein RC-Glied, wobei die Signalleistung nur im Widerstand R des Substrates verloren gehen kann. Zur Verlustminimierung gibt es somit zwei Wege: $R \Rightarrow 0$ oder $R \Rightarrow \sim$.

Als Substrat kommt insbesondere Silizium in Betracht, da dieses in den meisten modernen Fertigungstechnologien sehr niederohmig ist und die Substratverluste entsprechend hoch sein können. Bei der Verwendung eines Galliumarsenid-Substrates treten die unerwünschten Signalverluste nicht im gleichen Maße auf, wie bei einem Substrat aus Silizium, da Galliumarsenidwafer wesentlich hochohmiger sind.

Prinzipiell kann die Erfindung bei jedem beliebigen Wafermaterial verwendet werden. Der Nutzen hängt jedoch stark vom Wafermaterial ab, auf dem man fertigt. Der spezifische Widerstand des Wafermaterials kann zwischen 0,01 Ωcm und bis zu 10 MΩcm liegen.

Die Erfindung und deren Vorteile werden anhand der nachfolgenden Figuren weiter erläutert. Es zeigen:

Figur 1　　einen Ausschnitt aus einer erfindungsgemäßen Halb- leiteranordnung im Querschnitt,

Figur 2　　das Verhältnis eines Anschlußelementes und einer unterlegten Isolationsschicht in der Draufsicht,

Figur 3　　ein Ausführungsbeispiel eines Trench-Gitters,

Figur 4　　einen Ausschnitt einer Halbleiteranordnung mit meh- reren Anschlußelementen in der Draufsicht und.

Figur 5　　einen Querschnitt durch die erfindungsgemäße Halb- leiteranordnung mit einer konkreten Ausgestaltung des Trench-Gitters.

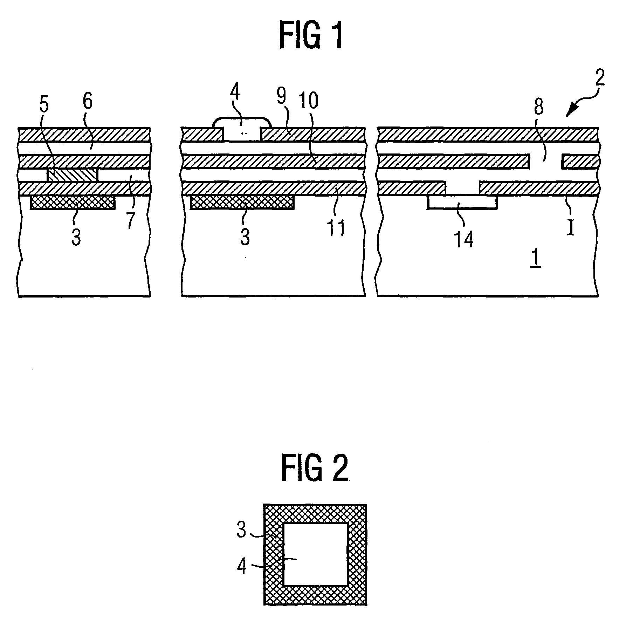

Figur 1 zeigt in einer Schnittdarstellung einen Ausschnitt einer erfindungsgemäßen Halbleiteranordnung. Auf einem Substrat 1, welches vorzugsweise aus Silizium besteht, ist auf einer ersten Hauptseite I eine Metallisierung 2 aufgebracht. In dem Substrat 1 ist wenigstens ein Bauelement in Form von in dem Substrat gelegenen Wannen vorgesehen. Stellvertretend für ein derartiges Bauelement steht die aus der Wanne 14 und dem Substrat 1 gebildete Diode. Selbstverständlich kann die erfindungsgemäße Halbleiteranordnung eine Vielzahl an Bauelementen, die beliebig miteinander verschaltet sein können, beinhalten.

Die Metallisierung 2 besteht im vorliegenden Ausführungsbeispiel aus zwei Metallisierungsebenen. Jede Metallisierungsebene weist Leiterbahnen 6, 7 auf, die durch eine Oxidschicht 10 voneinander getrennt sind. Zwischen der ersten Metallisierungsebene mit den Leiterbahnen 7 und der ersten Hauptseite I des Substrates 1 ist eine weitere Oxidschicht 11 aufgebracht. Zum Schutz der obersten Metallisierungsebene (Leiterbahnen 6) ist ebenfalls eine Oxidschicht 9 oder eine Passivierung aufgebracht. Diese weist in bekannter Weise Ausnehmungen auf, durch die ein extern kontaktierbares Anschlußelement 4 mit einer der Leiterbahnen 6 verbunden werden kann. Die Leiterbahnen der unteren und der oberen Metallisierungsebene können, müssen aber nicht durch Durchkontaktierungen 8 miteinander verbunden sein. Beispielhaft weist die untere Metallisierungsebene einen Polysilizium-Widerstand 5 auf. Polysilizium-Widerstände benötigen oft größere Flächen und führen damit zu einer nicht vernachlässigbaren Kapazität zum Substrat. Bei Einprägung hochfrequenter Ströme durch solche Polysilizium-Widerstände werden diese frequenzabhängig, da sich die Polysiliziumwiderstände dann in erster Ordnung wie ein RC-Glied verhalten. Durch die Isolationsschicht 3 unterhalb des Polysilizium-Widerstandes 5 kann diese Kapazität zum Substrat wesentlich verkleinert werden.

Die Erfindung ist selbstverständlich nicht auf eine Ausführung mit lediglich zwei Metallisierungsebenen beschränkt, sondern kann für jede beliebige Anzahl an Metallisierungsebenen Anwendung finden.

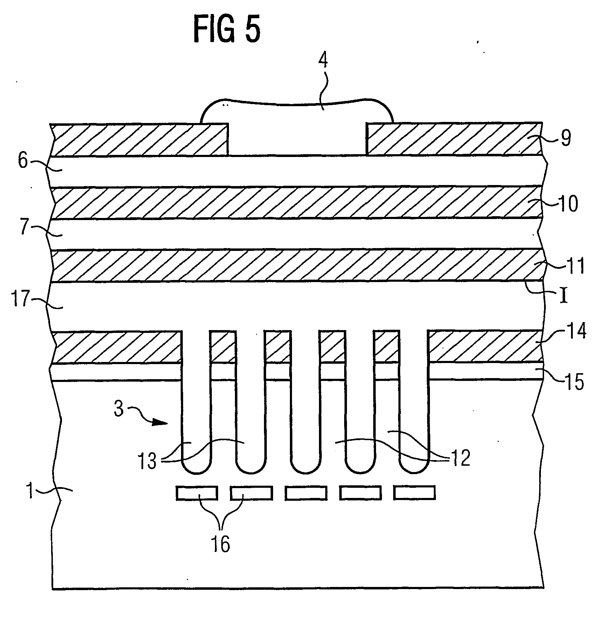

Es sei angenommen, daß an dem Anschlußelement 4 ein hochfrequentes Signal im Bereich einiger Gigahertz eingespeist wird. Um eine parasitäre Kapazität zwischen der Metallisierung des Anschlußelementes 4 und dem Substrat 1 zu verkleinern, ist erfindungsgemäß eine Isolationsschicht 3 unterhalb des Anschlußelementes 4 vorgesehen. Die Isolationsschicht 3 ist in der Form eines Trench-Gitters ausgebildet und reicht an die erste Hauptseite I des Substrates 1. Aus der Schnittdarstellung der Figur 1 wird gut ersichtlich, daß die Isolationsschicht 3 seitlich über die lateralen Begrenzungen des Anschlußelementes 4 hinausreicht, um eine bestmögliche Reduzierung der parasitären Kapazitäten, welche eine Verlustleistung zur Folge hätte, zu ermöglichen. Eine mögliche konkrete Ausgestaltung des Trench-Gitters ist in Figur 5 gezeigt.

Da auch Polysilizium-Widerstände eine signifikante kapazitive Kopplung zu dem Substrat aufweisen, ist ebenfalls unterhalb des Polysilizium-Widerstandes 5 eine Isolationsschicht 3 vorgesehen. Diese ragt seitlich ebenfalls über den Polysilizium-Widerstand 5 hinaus.

Das seitliche Hinausragen der Isolationsschicht 3 über die zu schützenden Teile der Metallisierung ist ebenfalls aus der Figur 2 gut ersichtlich, in der eine Draufsicht auf das Anschlußelement 4 und die seitlich hinausragende Isolationsschicht 3 dargestellt ist.

Aus der Figur 1 wird weiterhin gut ersichtlich, daß die Isolationsschicht 3 - mit Ausnahme der Bauelemente - nicht die gesamte Hauptseite I des Substrates bedecken muß. Es ist ausreichend, lediglich diejenigen Teile der Metallisierung mit einer Isolationsschicht zu unterlegen, die hochfrequente Signale führen oder an denen hochfrequente Signal ein- beziehungsweise ausgekoppelt werden.

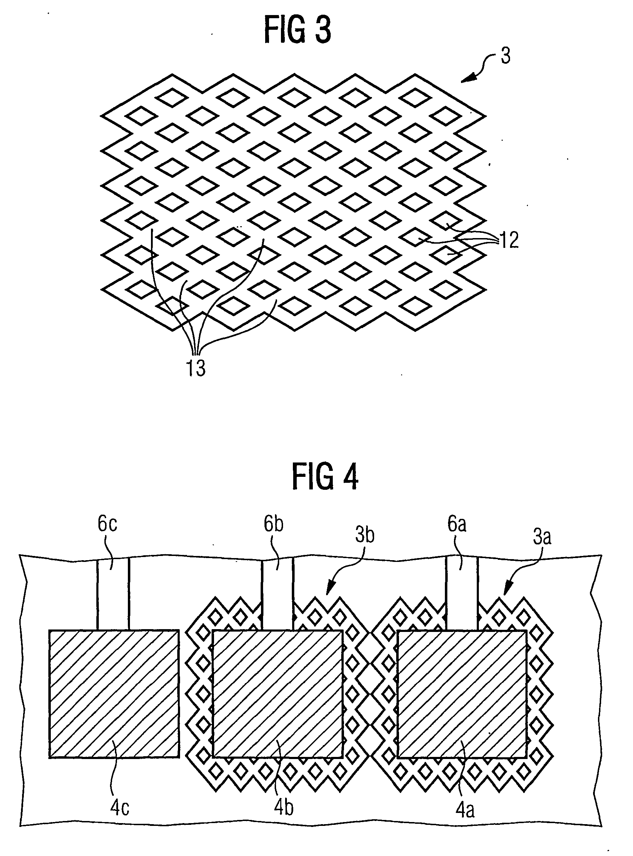

In der Figur 3 ist ein Ausgestaltungsbeispiel des erfindungsgemäßen Trench-Gitters dargestellt, wobei die in das Substrat geätzten Gräben mit 13 bezeichnet sind. Mit 12 sind demnach die nach dem Ätzschritt verbleibenden Substratsäulen bezeichnet. Die geätzten Gräben werden mit einem Isolator, vorzugsweise PSG-Glas, gefüllt.

Die einzelnen Zellen des Trench-Gitters liegen dabei vorzugsweise derart nebeneinander, daß bei einem optionalen nachfolgenden Oxidationsschritt das verbleibende Substratmaterial (Säulen 12) minimiert wird oder, falls prozesstechnisch möglich, ganz verschwindet, um eine durchgehende Isolationsschicht zu erhalten.

Besteht das Substrat aus Silizium, so entsteht nach dem optionalen Oxidationsschritt Siliziumoxid. Da dieses hochisolierend ist und eine relativ kleine Dielektrizitätskonstante aufweist, kann lediglich aufgrund dieser Layoutmaßnahme die spezifische kapazitive Leitfähigkeit um den Faktor 2 bis 3 reduziert werden.

Ein weiterer Vorteil der Erfindung besteht in einer erreichbaren Verkleinerung der Einstreuung von HF-Störsignalen in das Halbleitersubstrat. Durch konsequenten Einsatz der Trench-Gitter bei allen HF-kritischen Signalpfaden kann man das im komplexen Mixed-Signal-Chip-Design äußerst kritische Signalübersprechen ebenfalls erheblich vermindern.

Figur 4 zeigt in der Draufsicht einen Ausschnitt einer erfindungsgemäßen Halbleiteranordnung. Beispielhaft sind drei Anschlußelemente 4a, 4b, 4c mit jeweiligen Leiterbahnen 6a, 6b, 6c dargestellt. An dem Anschlußelement 4c wird beispielsweise die Versorgungsspannung angelegt. Die beiden anderen Anschlußelemente 4a, 4b werden mit einem hochfrequenten Signal beaufschlagt. Lediglich diese beiden Anschlußelemente 4a, 4b sind jeweils mit einem Trench-Gitter 3a, 3b unterlegt. Denkbar wäre auch, lediglich ein einziges Trench-Gitter unterhalb der Anschlußelemente 4a, 4b vorzusehen. Da an dem Anschlußelement 4c kein hochfrequentes Signal anliegt, ist das Trench-Gitter hier nicht notwendig. Prinzipiell kann jede kritische Signalleitungsstrecke, die nur Bauelemente in den Metallisierungsebenen enthält, mit Trench-Gittern unterlegt werden. Insbesondere sind diejenigen Leiterbahnen kritisch, die Hochfrequenz-Signale führen.

Figur 5 zeigt einen Querschnitt durch die erfindungsgemäße Halbeiteranordnung mit einem möglichen, konkreten Ausgestaltungsbeispiel des Trench-Gitters. Das Trench-Gitter ist unterhalb des Anschlußelementes gelegen und ragt seitlich über dieses hinaus. Im vorliegenden Ausführungsbeispiel ist auf das Substrat 1 eine Epitaxieschicht 15 aufgebracht, auf der ihrerseits ein Isolator 14, welcher z.B. thermisch oder mittels CVD-Abscheidung aufgebracht ist, gelegen ist. Ein weiterer Isolator 17, welcher an die erste Hauptseite I reicht, wird beim Auffüllen der Gräben 13 mitaufgebracht. Der Isolator 17 sowie die Gräben 13 bestehen vorzugsweise aus PSG-Glas. Aus der Figur 5 wird gut ersichtlich, daß zwischen den Gräben 13 Substratsäulen 12 bestehen bleiben. Diese verbleibenden Halbleitersäulen haben in vertikaler Richtung das gleiche Dotierungsprofil wie das Substrat 1. Die verbleibende Säule weist somit die Grunddotierung des Wafers auf. Die in der Figur 5 eingezeichnete Epetaxieschicht ist optional. Zwischen der Epetaxieschicht und dem Substrat bildet sich ein klassischer PN-Übergang mit einer relativ weiten Raumladungszone aus, da es sich vorzugsweise um einen nieder dotierten PN-Übergang handelt. Diese PN-Raumladungszone verhält sich wie eine Isolationsschicht und erzeugt eine weitere serielle Kapazität zum Substrat 1.

Weiterhin sind in der Figur 5 in dem Substrat 1 Bereiche 16 eingezeichnet, die einen sogenannten "Channel Stopper" darstellen. Diese beispielsweise implatierten Bereiche sind nicht zwangsweise notwendig, jedoch vorteilhaft. Um die erwünschte Wirkung zu erzielen, ist es ausreichend, wenn die Gräben 13 ca. 5 nm in das Substrat 1 reichen. Bereits bei dieser Tiefe wird eine gute Signalqualität bei der Einspeisung von hoch frequenten Signalen an dem Anschlußelement 4 erzielt. Selbstverständlich könnte die Grabentiefe auch wesentlich größer sein. Die Grabentiefe hängt im wesentlichen von dem verwendeten Halbleitermaterial sowie der Frequenz des an dem Anschlußelement eingespeisten Signales ab.

Durch die Nutzung der in Halbleiterprozessen zur Verfügung stehenden Trench-Technik kann die parasitäre Kapazität zwischen Metallisierungsstrukturen und Substrat um den Faktor 2 bis 3 reduziert werden. Die Trench-Technik wurde bislang zur wesentlichen Verbesserung der elektrischen Isolation zwischen Bauelementen in einem Substrat und zur drastischen Verkleinerung der benötigten Chipfläche pro Bauelement entwickelt und wird derzeit dafür weitverbreitet eingesetzt. Die Erfindung eröffnet eine weitere Einsatzmöglichkeit der bekannten Trench-Technik und bietet dadurch eine einfache und kostengünstige Möglichkeit, die Hochfrequenz-Signalübertragung bei Hochfrequenz-Anordnungen auf Halbleitersubstraten wesentlich zu verbessern.

Die Erfindung läßt sich ebenfalls beim Testen von HF-Bauelementen einsetzen, indem diejenigen Anschlußelemente, die von einem Meßkopf kontaktiert werden, mit dem Trench-Gitter unterlegt werden. Werden zudem die Zuleitungen, das heißt die Leiterbahnen zu dem zu testenden Bauelement mit der Isolationsschicht unterlegt, kann die störende kapazitive Kopplung wesentlich reduziert werden.

Bezugszeichenliste

| 1 | Substrat |
|---|---|
| 2 | Metallisierung |
| 3 | Isolationsschicht |
| 4 | Anschlußelement |
| 5 | Polysilizium-Widerstand |
| 6, 7 | Leiterbahn |
| 8 | Durchkontaktierung |
| 9, 10, 11 | Oxidschicht |
| 12 | Substratwand |
| 13 | Graben |

**Patentansprüche**

1. Verfahren zur Herstellung einer Halbleiteranordnung mit einem Substrat (1), das wenigstens ein darin integriertes Bauelement aufweist und auf dessen erster Hauptseite (I) eine Metallisierung (2) vorgesehen ist, wobei zumindest Teile der Metallisierung (2) mit einer in dem Substrat (1) gelegenen Isolationsschicht (3) unterlegt sind, wobei

- auf ein mit einer Grunddotierung versehenes Substrat (1) eine Epitaxieschicht (15) aufgebracht und zwischen dem Substrat und der Epitaxieschicht ein PN-Übergang ausgebildet wird,
- auf der Epitaxieschicht (15) ein Isolator (14) thermisch oder mittels CVD-Abscheidung aufgebracht wird,
- ein rechteck- oder rautenförmiges Trench-Gitter und ein das integrierte Bauelement umgebender Trench-Graben mit dem gleichen Verfahrensschritt durch Grabenätzen hergestellt werden,
- die Isolationsschicht (3) durch anschließendes Auffüllen des Trench-Gitters mit einem Isolator hergestellt wird und hierbei ein weiterer Isolator (17), welcher an die erste Hauptseite (I) reicht, auf den Isolator (14) mit aufgebracht wird und
- die Isolationsschicht (3) an Stellen im Substrat (1) erzeugt wird, an denen in einem späteren Verfahrensschritt Anschlusselemente, die sich im Signalpfad von Hochfrequenzsignalen befinden, erzeugt werden.

2. Verfahren nach Anspruch 1, bei dem implantierte Bereiche (16) in dem Substrat (1) unter den Gräben (13) des Trench-Gitters als Channel-Stopper hergestellt werden.

**Claims**

1. Method for producing a semiconductor arrangement comprising a substrate (1), which has at least one component integrated therein and on whose first main side (I) a metallisation (2) is provided, wherein at least parts of the metallisation (2) are underlaid with an insulation layer (3) located in the substrate (1), wherein

- an epitaxial layer (15) is applied to a substrate (1) provided with a basic doping and a PN-junction is formed between the substrate and the epitaxial layer,
- an insulator (14) is applied on the epitaxial layer (15) thermally or by means of CVD deposition,
- a rectangular or rhomboidal trench lattice and a trench surrounding the integrated component are produced by means of the same method step by trench etching,
- the insulating layer (3) is produced by subsequently filling the trench lattice with an insulator and in this case a further insulator (17) which reaches as far as the first main side (I), is concomitantly applied to the insulator (14), and
- the insulation layer (3) is produced at locations in the substrate (1) at which connection elements situated in the signal path of radio-frequency signals are produced in a later method step.

2. Method according to Claim 1, in which implanted regions (16) in the substrate (1) below the trenches (13) of the trench lattice are produced as channel stoppers.

**Revendications**

1.  Procédé de production d'un dispositif à semi-conducteur comprenant un substrat (1) qui a au moins un composant qui y est intégré et sur la première face (I) principale duquel est prévue une métallisation (2), une couche (3) isolante mise dans le substrat (1) étant sous-jacente à au moins des parties de la métallisation (2), dans lequel

    - on dépose une couche (15) par épitaxie sur un substrat (1) muni d'un dopage de base et on forme une jonction PN entre le substrat et la couche par épitaxie,
    - on dépose thermiquement ou au moyen d'un dépôt CVD un isolant (14) sur la couche (15) par épitaxie,
    - on produit par attaque de sillon par le même stade de procédé un réseau trench en forme de rectangle ou de losange et un sillon trench entourant le composant intégré,
    - on produit la couche (3) isolante en remplissant ensuite le réseau trench d'un isolant et on dépose à cet effet sur l'isolant (14) un autre isolant (17) qui va jusqu'à la première face (I) principale et
    - on produit la couche (3) isolante en des emplacements du substrat (1) où l'on produit dans un stade ultérieur du procédé des éléments de borne, qui se trouvent dans le trajet de signaux de haute fréquence.

2.  Procédé suivant la revendication 1, dans lequel on produit des parties (16) implantées dans le substrat (1) sous les sillons (13) du réseau trench en tant que channel-stopper.

## FIG 1

## FIG 2

# FIG 3

# FIG 4

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5665633 A
- US 6093599 A
- DE 3825547 A1
- KR 20000033521 A
- US 6274920 B1
- EP 844660 A1

**In der Beschreibung aufgeführte Nicht-Patentliteratur**

- **H.B. ERZGRÄBER ; T. GRABOLLA ; H.H. RICHTER ; P. SCHLEY ; A. WOLFF.** Novell Burried Oxide Isolation for Monolitic RF Inductors on Silicon. *IEDM 98,* 535-539